# EUROPEAN PATENT APPLICATION

(11) **EP 2 746 792 A1**
(43) Date of publication of application: **25.06.2014**
(21) Application number: 12198633.5
(22) Date of filing: 20.12.2012
(51) Int. Cl.: G01R 31/26, H01S 5/00, H01L 21/66

(54) **Solid state lighting element, peak wavelength estimation method and binning method**

(71) Applicant: NXP B.V., 5656 AG Eindhoven (NL)
(72) Inventor: Surdeanu, Radu, Redhill, Surrey RH1 1NY (GB); Buscema, Michele, Redhill, Surrey RH1 1NY (GB); Cox, Matthijs, Redhill, Surrey RH1 1NY (GB); Koenderink, Femius, Redhill, Surrey RH1 1NY (GB)
(74) Representative: Hardingham, Christopher Mark

(57) **Abstract**

Disclosed is a method of estimating a peak wavelength of a solid state lighting element, the method comprising determining (330) a thermal admittance spectrum of the solid state lighting element, said spectrum identifying the energy levels of the trap states in the band gap of the solid state lighting element; identifying (350) the shallow trap states in said spectrum; and estimating (370) said peak wavelength from the respective energy gaps between the identified shallow trap states and the band gap boundary. A binning method for characterizing solid state lighting elements utilizing this estimation method and a solid state lighting element adapted to implement this estimation method are also disclosed.

## Description

### FIELD OF THE INVENTION

The present invention relates to a method of estimating the peak wavelength of a solid state lighting (SSL) element.

The present invention further relates to a method of binning a plurality of SSL elements using the peak wavelength estimation method.

The present invention yet further relates to a SSL element adapted to be subjected to such a peak wavelength estimation method.

The present invention yet further relates to an apparatus comprising such a SSL element.

### BACKGROUND OF THE INVENTION

Solid State Lighting (SSL), lighting using Light Emitting Diodes (LEDs), has become a fast growing research and development topic, as well as a large emerging market in recent years. This is because SSL offers many benefits, such as energy consumption reduction, improved quality of light, reliability and longer lifetime compared to e.g. incandescent lighting. This has caused SSL to enter a wide range of application domains, from general illumination devices, display devices to automotive applications.

However, SSL elements face several fundamental challenges that originated from the way the SSL elements are manufactured. Even SSL elements from a single manufacturing batch can exhibit large variation in output wavelengths (peak wavelengths), output intensity and forward voltages. These variations have several causes.

For instance, lattice mismatch between the layers of a (double) heterostructure, e.g. AllnGaN for green and blue SSL elements or AllnGaP for red SSL elements and the substrate such as a sapphire substrate results in the presence of intrinsic stress in the structure, which causes the presence of a large amount (∼10¹⁰ - 10¹² cm⁻²) of defects; e.g. stochastic defects, such as stacking faults, threading dislocations, and interface states, which defects are present at the interfaces between the contacts and the SSL structure, between a buffer layer such as a GaN buffer layer and the Multiple Quantum Wells (MQW), and so on.

Another source of such variations is material segregation; highly efficient light emitting quantum dots of various dimensions are present in the MQW due to local variations in Indium concentration in the layers defining the MQW. High internal electric fields, leading to Stark effect, can lead to variations in wavelengths of the emitted light, as can process variations across the wafer.

These variations affect several aspects of SSL systems, such as the logistics of the produced SSLs. Because the end user typically demands a well-defined SSL system in terms of peak wavelength, flux output and forward voltage, the manufacturer of the SSL system has to apply expensive and time-consuming binning procedures to ensure that the SSL systems are grouped accordingly. In particular peak wavelength binning can be expensive as well as time-consuming, as this requires the optical measurement and subsequent interpretation of the output spectrum of the SSL elements, followed potentially by the adjustment of the control electronics of the SSL element to ensure that the SSL element produces light of the desired peak wavelength.

### SUMMARY OF THE INVENTION

The present invention seeks to provide a less expensive method of estimating a peak wavelength of a SSL element.

The present invention further seeks to provide a less expensive SSL element peak wavelength binning method.

The present invention further seeks to provide a SSL element that facilitates such less expensive peak wavelength estimation.

The present invention further seeks to provide a device comprising such a SSL element.

According to an aspect of the present invention, there is provided a method of electrically estimating a peak wavelength of a solid state lighting device, the method comprising determining a thermal admittance spectrum of the solid state lighting element, said spectrum identifying the energy levels of the trap states in the band gap of the solid state lighting element; identifying the shallow trap states in said spectrum; and estimating said peak wavelength from the respective energy gaps between the identified shallow trap states and the band gap boundary.

The present invention is based on the known principle of applying thermal admittance spectroscopy (TAS) to determine the shallow and deep trap states of a SSL element. The present invention combines this known principle with the insight that in a typical SSL element the radiative relaxation from such trapped states predominantly occurs from shallow states, whereas deep states typically exhibit radiationless decay. Therefore, by identifying the shallow states or quantum wells in the bandgap material of the SSL element, the energy gap of the selected states to the band gap boundary can be used to generate an estimate of the intrinsic spectral composition of the light output of the SSL element including the peak wavelength of the SSL element, which may be identified as the wavelength associated with the highest number of identified shallow trap states. The method of the present invention therefore can provide peak wavelength information for a SSL element without requiring expensive optical detection techniques, thus reducing the cost associated with obtaining such peak wavelength information.

In an embodiment, the step of determining the thermal admittance spectrum comprises repeating the steps of bringing the solid state lighting device to a desired temperature; exposing the solid state lighting device to an excitation current of varying frequency; and determining the change in the capacitance or conductance of the solid state lighting element as a function of said frequency.

The step of bringing the solid state lighting device to a desired temperature may comprise exposing the solid state lighting element to a pulse width modulated current comprising a first component for driving the solid state lighting element and a second component for estimating the temperature of the solid state lighting element, which has the advantage that no separate heating stage is required to bring the SSL element to the desired temperature. Instead, the drive component of the pulse width modulated current can be used to heat the SSL element, whereas the measurement component may be used to estimate the temperature of the SSL element, as is explained in more detail in US 8,278,831. This allows for the accurate (±1 °C) and fast (∼10µs) measurement of SSL element temperature without the need for an external temperature sensor. Incidentally, the measurement component of the pulse width modulated current may instead or additionally be used to perform the admittance measurement of the SSL element, in which case the drive component of the pulse width modulated current may be used to provide the SSL element with the current waveform required for performing the thermal admittance spectroscopy.

In an embodiment, the method further comprises applying a state selection threshold to said spectrum to identify the shallow trap states located in between said state selection threshold and a band gap boundary. This is for instance advantageous when the shallow states or quantum wells cannot be easily identified in the TA spectrum or when the identified shallow states do not provide an accurate enough estimation of the peak wavelength of the SSL element. By applying a trap state selection using an empirically determined state selection threshold, the (shallow) trap states in the semiconductor material(s) of the SSL element that are most likely to exhibit emissive decay can be selected from all the states detected by TAS.

In an embodiment, said state selection threshold may be determined using a benchmarking procedure that comprises optically measuring the respective peak wavelengths of a plurality of solid state lighting elements; for each solid state lighting element of said plurality, determining its thermal admittance spectrum; and applying a fitting algorithm to the plurality of thermal admittance spectra to determine a state selection threshold for which the average of the respective peak wavelengths estimated from the respective energy gaps of the trap states in said spectra that are located in between said threshold and the band gap boundary deviates from the average of the measured respective peak wavelengths by less than a predefined threshold.

This approach can be followed because different batches of the same product tend to exhibit comparable defect characteristics and spreads, such that once a state selection threshold is found for a batch of SSL elements that selects a set of trap states such that the estimated peak wavelength of each SSL element accurately corresponds to the measured peak wavelength of the SSL element, this state selection threshold can be applied to other batches of the same SSL element.

In accordance with another aspect of the present invention, there is provided a method of binning a plurality of solid state lighting elements into a plurality of bins characterised by peak wavelength, the method comprising estimating the peak wavelength of each solid state lighting element by an embodiment of the peak wavelength estimation method of the present invention; and assigning the solid state lighting element to one of said bins based on the estimated peak wavelength.

This binning method benefits from the ability to accurately estimate a peak wavelength of an individual SSL element electrically in that the binning procedure can be performed more quickly and more cost effectively without compromising customer requirements.

According to yet another aspect of the present invention, there is provided a solid state lighting element comprising a heterojunction defined by a quantum well material layer sandwiched between an n-type semiconductor layer and a p-type semiconductor layer; a first current source driver adapted to provide said heterojunction with a first current output during an operating mode of the solid state lighting element; a second current source driver adapted to provide said heterojunction with a variable frequency current output during a peak wavelength estimation mode of the solid state lighting element; and at least one sensing electrode in conductive contact with said heterojunction adapted to measure the change in capacitance or conductance across said heterojunction. Such a SSL element advantageously facilitates the measurement of a TAS, which allows for a more efficient binning of the SSL element, as previously explained.

The first current source driver and the second current source driver may be different current source drivers, e.g. may be provided as separate current drivers, or may be the same current source driver, i.e. a single current source driver combining the functionality of the first and second current source drivers.

In an embodiment, the first current source driver comprises a first driver circuit adapted to provide said heterojunction with the first current output, wherein the first driver circuit has a control switch for interrupting the supply of the first current output; a second driver circuit for generating a second current output for driving the solid state lighting element, wherein the second driver circuit has a control switch for interrupting the supply of the second current output; and wherein the output of the first current source driver comprises the combination of the first and second driver circuit outputs, in the form of a pulse width modulated output current which alternates between a high current including the first current output generated by the first driver circuit and a low current comprising the second current output generated by the second driver circuit.

Such a first current source driver is known per se from US 8,278,831 and may be used to control the junction temperature of the SSL element in a sensorless manner, as explained in more detail in this prior art application.

Alternatively, the solid state lighting element may comprise a temperature sensor to measure the increase in (junction) temperature of the SSL element, e.g. during the determination of the thermal admittance spectrum of the SSL element.

The solid state lighting element preferably comprises a light emitting diode.

In accordance with a further embodiment of the present invention, there is provided a device comprising the solid state lighting element according to an embodiment of the present invention. Such a device benefits from the fact that the SSL element can be manufactured more cost-effectively as previously explained. Such a device may for instance be a lighting device, a display device, an automotive device and so on.

### BRIEF DESCRIPTION OF THE EMBODIMENTS

Embodiments of the invention are described in more detail and by way of nonlimiting examples with reference to the accompanying drawings, wherein:
FIG. 1 schematically depicts a band structure of a heterojunction SSL element;
FIG. 2 schematically depicts an aspect of a SSL element according to an embodiment of the present invention;
FIG. 3 depicts a flow chart of a method of estimating a peak wavelength of an SSL element according to an embodiment of the present invention;
FIG. 4 depicts a flow chart of a method of determining a state selection threshold for use in the method of FIG. 3; and
FIG. 5 depicts a flow chart of a SSL element binning method according to an embodiment of the present invention.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

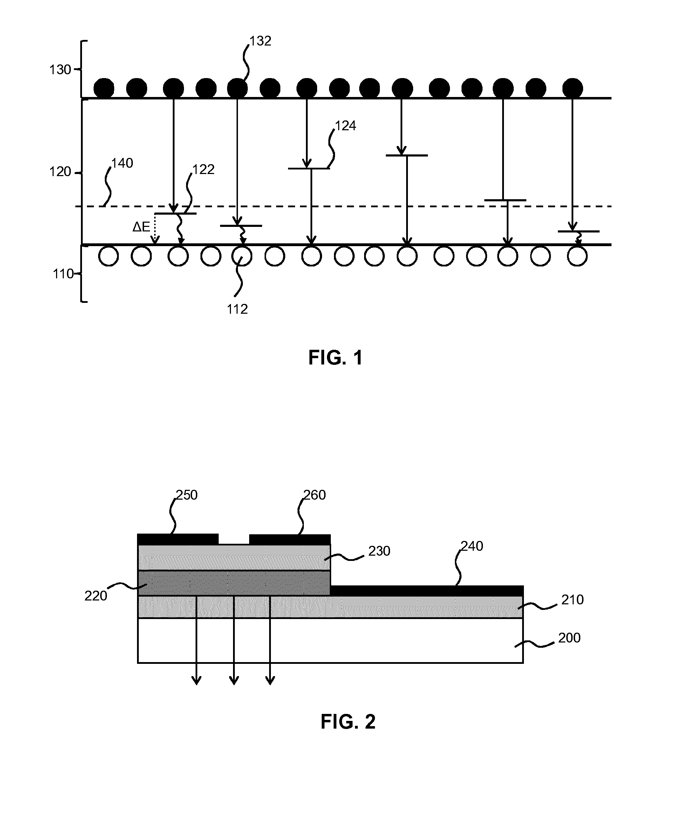

FIG. 1 schematically depicts a band structure of a heterojunction SSL element, such as the SSL element shown in FIG. 2. A valence band 110, which is typically located in a semiconductor material 210 doped with a p-type impurity is separated by a band gap 120 from a conduction band 130, which is typically located in a semiconductor material 230 doped with a n-type impurity. The valence band 110 exhibits conduction of electron holes 112 whereas the conduction band exhibits conduction of electrons 122, as is of course well-known. The band gap comprising multiple quantum wells or shallow states 122 is typically created by a quantum well material layer 220 in between the p-type semiconductor material 210 and the n-type semiconductor material 230. The quantum well material 220 typically further comprises deep trapping states 124.

Shallow trapping states 122 derive their name from the close proximity to the band gap boundary, and often lie in the region between this boundary and the Fermi level. In contract, deep trapping states are relatively far away from both band gap boundaries, i.e. lie approximately in the middle of the band gap 120. Decay processes in the heterojunction involving shallow trapping states 122 are predominantly responsible for the radiative emission of heterojunction SSL elements, where direct (conduction) band to (valance) band emissive radiation plays no significant part (contrary to homo-junction SSL elements). A more detailed description of the recombination of electron-hole pairs in (heterojunction) SSL elements can be found in many textbooks and on-line resources; see e.g. https://courses.cit.cornell.edu/ece533/Lectures/handout7. pdf as retrieved from the Internet on 18 December 2012.

Hence, by determining the energy ΔE of the shallow trap states 122 relative to the band gap boundary, an estimate of the wavelength λ of the radiative emission from the shallow trapped state can be given from ΔE *= hc*/*λ,* in which h is Planck's constant and c is the speed of light. By determining the emission wavelength λ of each shallow trapped state 122 and mapping these wavelengths, an estimated radiative emission spectrum of the SSL element is compiled that serves as an estimation of the peak wavelength of the SSL element. More particularly, the peak wavelength may be identified as the wavelength that is associated with the largest number of mapped shallow trap states.

It should be appreciated that FIG. 1 is a highly simplified representation of a band structure of a heterojunction SSL element. Similarly, FIG. 2 is a highly simplified representation of such a heterojunction SSL element. For instance, the SSL element may comprise additional semiconductor layers and heterojunctions, Bragg reflectors, hole blocking layers, electron blocking layers and so on, which is all known per se in the art. Also, any suitable materials may be chosen for the SSL element. For instance, the substrate 200 may be any suitable substrate such as a (transparent) sapphire substrate 200 in case the SSL element is arranged to emit light through the substrate 200 as indicated by the arrows in FIG. 2.

The semiconductor layers 210 and 230 may comprise any suitable semiconductor material, e.g. Ga-based semiconductor layers, e.g. AllnGaN, AllnGaP, and so on, with a multiple quantum well layer of e.g. GaN, InGaN and so on. The electrodes 240, 250 and optional separate sensing electrode 260 may take any suitable form and may be realized using any suitable electrically conductive material, e.g. suitable metals.

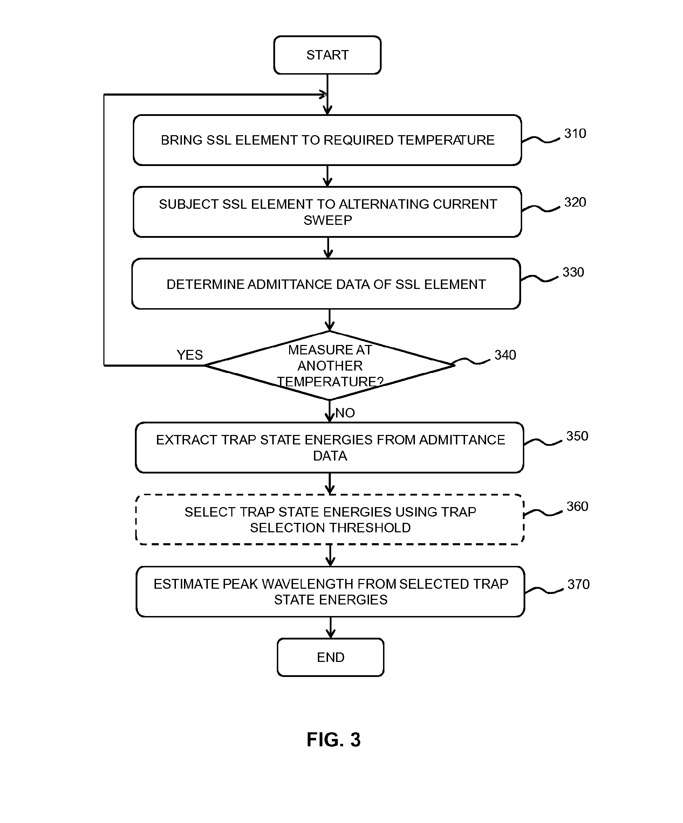

Many suitable materials have been well-documented, and it should be understood that the present invention is not limited to a SSL element having a particular type of structure with a particular combination of materials. Instead, the present invention is based on the insight that a SSL element may be adapted such that it can be driven to provide admittance spectroscopy data, from which peak wavelength information may be derived. The SSL element may comprise a driver architecture that can provide such a drive signal or may be connected to a current source, e.g. during binning procedures, that can provide the SSL element with such a current drive signal, as will be explained in more detail with the aid of FIG. 3.

To perform thermal admittance spectroscopy, an oscillating driving signal is fed into the SSL element, with or without a dc offset, and the response of the system is measured. The impedance (or admittance) can then be determined. Impedance can be converted into capacitance and conductance. By doing a frequency sweep at various temperatures, the conductance exhibits different peak positions at different temperatures when the frequency hits a resonance with the (shallow) donor levels. The shift in peak conductance corresponds to the emission rate, which then plotted in an Arrhenius plot gives information on the energy of the (full) band gap, as is explained in further detail by J.H. Zhao et al. in Applied Physics Letters 62, pages 2810-2812 (1993).

In thermal admittance spectroscopy, it is known per se that at a fixed temperature, as the frequency of the test signal is reduced, deeper traps are able to respond and contribute to the capacitance and conductance. Similarly, as the temperature increases, the emission rate of a defect increases and the trap can contribute to the measured property at higher frequencies. At a threshold in frequency or temperature, the deep level appears as a step in the capacitance, or a peak in the conductance. The temperature of the inflection point of each plot of capacitance versus temperature at a fixed frequency is used along with the frequency, as one point in an Arrhenius plot. The energy of the defects can be obtained from plotting pairs of frequency and temperature points in an Arrhenius plot of emission rate (frequency of measurement) versus 1/*kT*, in which *T* is temperature and *k* is the Bolzmann constant.

It is furthermore well-known, see e.g. O.V. Kucherova et al. in Inorganic Materials, Vol. 47(14), pages 1574-1578 (2011) that in TAS, the amplitude of the spectral peaks from quantum wells exhibit a sharp dependence on the bias applied to the material, such that the emission from quantum wells can be reliably distinguished from emissions from a deep trap state, e.g. a bulk deep centre.

Hence, by performing a frequency sweep at various temperatures and various bias conditions, the measured conductance will exhibit different peak positions at different temperatures when the frequency resonates with a shallow donor level or a deep trap state in the heterojunction of the SSL element. The energy levels of the various (shallow and deep) trap states can be determined by the construction of an Arrhenius plot as explained above.

Hence, in step 310 of the peak wavelength estimation method shown in FIG. 3, the SSL element is brought to the required temperature for the TA measurement, after which the SSL element is subjected to the appropriate alternating current sweep in step 320, with the response of the SSL element to this alternating current sweep being determined in step 330. This may be realized in a number of ways. For instance, the SSL element may be brought to the required temperature by placing the SSL element in a heating stage and by monitoring the SSL element temperature using a temperature sensor, which may form part of the SSL element.

However, in a preferred alternative embodiment, the SSL element is brought to the desired temperature using the current waveform as disclosed in US 8,278,831, and in particular paragraphs [0045]-[0062] of this application. To this end, the SSL element may comprise a first driver circuit adapted to provide its heterojunction with a first current output, wherein the first driver circuit has a control switch for interrupting the supply of the first current output, a second driver circuit for generating a second current output for driving the solid state lighting element, wherein the second driver circuit has a control switch for interrupting the supply of the second current output and wherein the output of the first current source driver comprises the combination of the first and second driver circuit outputs, in the form of a pulse width modulated output current which alternates between a high current including the first current output generated by the first driver circuit and a low current comprising the second current output generated by the second driver circuit.

The thermal admittance current sweep, i.e. an alternating current in which the frequency of the current is varied in a systematic manner, in step 320 may also be produced by this driver arrangement or by an additional driver arrangement in which a high current signal provides the required current sweep and a low current signal is used to sense the change in admittance, e.g. conductance or capacitance, across the heterojunction of the SSL element in step 330 to obtain the thermal admittance data. In this embodiment, the driving electrodes 240, 250 of the SSL element are also used as sensing electrodes. The SSL element may alternatively comprise one or more separate sensing electrodes 260, in which case the change in admittance of the heterojunction caused by the alternating current sweep provided in step 320 is measured by one or more separate electrodes 260. In this embodiment, the driver circuit for providing the alternating current sweep may simply generate this alternating current sweep without alternating this signal with a measurement current according to the teachings of US 8,278,831. The exact electrode and driver arrangement of the SSL element chosen to implement the ability to generate a thermal admittance spectrum is not particularly limited; any suitable arrangement may be chosen.

In step 340, it is decided if the determination of the thermal admittance spectrum is complete, i.e. if the SSL element is subjected to the alternating current sweep, i.e. an alternating current in which the frequency of the current is varied in a systematic manner, at all targeted discrete temperatures. If this is not the case, the method reverts back to step 310, in which the SSL element temperature is adjusted to the next targeted temperature, after which steps 320 and 330 are repeated, i.e. the admittance data at the next targeted temperature is generated and obtained.

Once the admittance data at all targeted discrete temperatures has been obtained, the method proceeds to step 350 in which the energies of the trap states identified in the thermal admittance spectrum are derived from the thermal admittance spectrum using Arrhenius plots as previously explained. This preferably is done automatically, e.g. using a suitably programmed data processor. Step 350 may further comprise identifying only shallow trap states from the thermal admittance spectrum in case the spectrum has been obtained by subjecting the heterojunction of the SSL element to appropriate bias voltages, as explained in more detail in the aforementioned paper by O.V. Kucherova et al.

Alternatively, in case it proves cumbersome to separate the shallow trap states from the deep trap states in this manner, a deep level transient spectrum (DLTS) may be determined for the SSL element, which as is well known per se identifies deep trap states only, such that the state energies derived from the TA spectrum and the DLTS spectrum may be combined such that only the states that are unique to the TA spectrum are retained, as these are likely to be the shallow trap states in the band gap or multiple quantum well material 220.

In an embodiment, the method may next proceed to step 370 to generate the estimated peak wavelength of the SSL element by determining the emission wavelength λ of each shallow trapped state 122 and mapping these wavelengths as previously explained.

In an alternative embodiment, the method first proceeds to step 360 prior to proceeding to step 370, in which the appropriate trap states are being selected using an empirically determined state selection threshold 140 as shown in FIG. 1. The state selection threshold 140 defines the energy cut-off point at which states 122 are considered to be emissive states, such that all states 122 lying in between the state selection threshold 140 and the band gap boundary (in particular with the valence band) are considered emissive states. This for instance may be advantageous if it is not straightforward to detect which of the states identified in the TA spectrum are in fact shallow (quantum well) states, or in a scenario where the identified shallow states do not provide an accurate peak wavelength estimation of the SSL element, for instance because some dark states have erroneously been included or some emissive states have erroneously been excluded.

At this point it is noted that preferably at least some and more preferably all of steps 350, 360 and 370 are performed automatically, e.g. using a suitably programmed data processor.

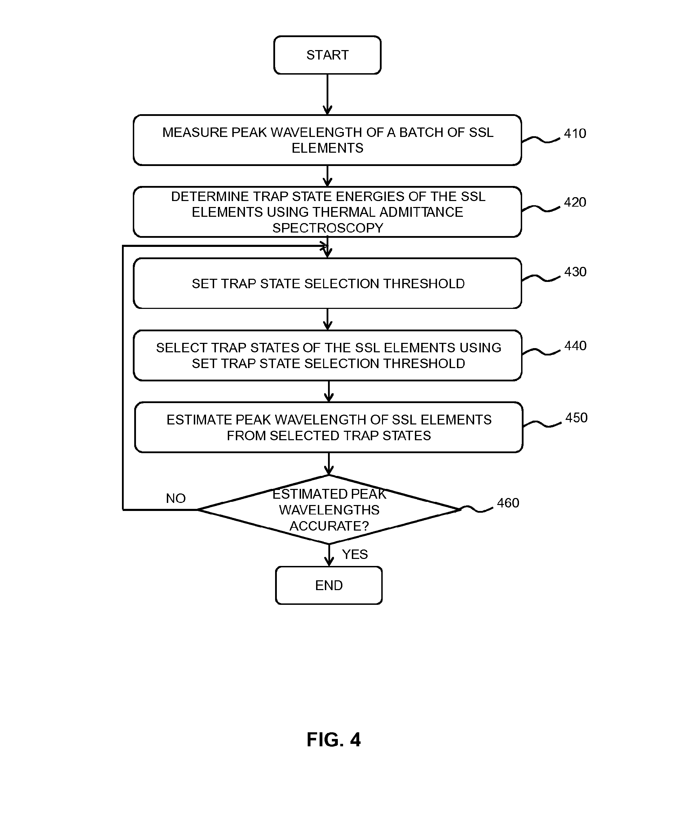

In an embodiment, the state selection threshold 140 may be empirically determined using the benchmarking method shown in FIG. 4. In this method, the peak wavelengths of a batch of SSL elements is determined in step 410 in a usual manner, i.e. by optically measuring the peak wavelength, as is of course well-known. In step 420, the TA spectra of the SSL elements in this batch are also determined. It is noted that the order of steps 410 and 420 of course may be altered.

Next, an initial state selection threshold 140 is chosen, and the peak wavelengths of the SSL elements from the batch are estimated in step 450 from the trap states of the SSL elements selected in step 440 that are located in between the initial state selection threshold 140 and the band gap boundary as previously explained. For each SSL element, the measured peak wavelength is compared to the estimated peak wavelength in step 460, and an average (absolute) deviation between the measured peak wavelengths and the estimated peak wavelengths is calculated.

In case the average (absolute) deviation falls below a predefined value, the estimated peak wavelengths are sufficiently accurate such that the state selection threshold 140 may be applied to further batches of SSL elements without having to optically determine the peak wavelength of the SSL elements of these further batches. In case the average (absolute) deviation falls below a predefined value, the method reverts back to step 430, where the state selection threshold 140 is adjusted in accordance with the deviation information.

If the averaged peak wavelength comparison has indicated that the estimated peak wavelengths are predominantly red-shifted compared to the measured peak wavelengths, the state selection threshold 140 is likely too low because higher energy trap states, which generate lower wavelength, i.e. blue-shifted light, have been erroneously omitted from the trap states selected in step 440 such that upon reverting back to step 430 the state selection threshold 140 is increased and steps 440, 450 and 460 are repeated with the increased state selection threshold 140.

If the averaged peak wavelength comparison has indicated that the estimated peak wavelengths are predominantly blue-shifted compared to the measured peak wavelengths, the state selection threshold 140 is likely too high because it has been wrongly assumed that higher energy trap states in the trap states selected in step 440 contributed to the emission spectrum of the SSL element such that upon reverting back to step 430 the state selection threshold 140 is decreased and steps 440, 450 and 460 are repeated with the decreased state selection threshold 140. This process is repeated until the average (absolute) deviation between the measured peak wavelengths and the estimated peak wavelengths becomes acceptable.

At this point it is noted that preferably at least some and more preferably all of steps 410, 420, 430, 440, 450 and 460 are performed automatically, e.g. using a suitably programmed data processor.

The peak wavelength estimation method of the present invention may be advantageously applied in a binning process of SSL elements. In a binning process, the SSL elements are categorized (binned) such that SSL elements that share one or more characteristic properties, e.g. peak wavelengths, are grouped together, to ensure that a customer is provided with SSL elements that have the intended and desirable characteristics.

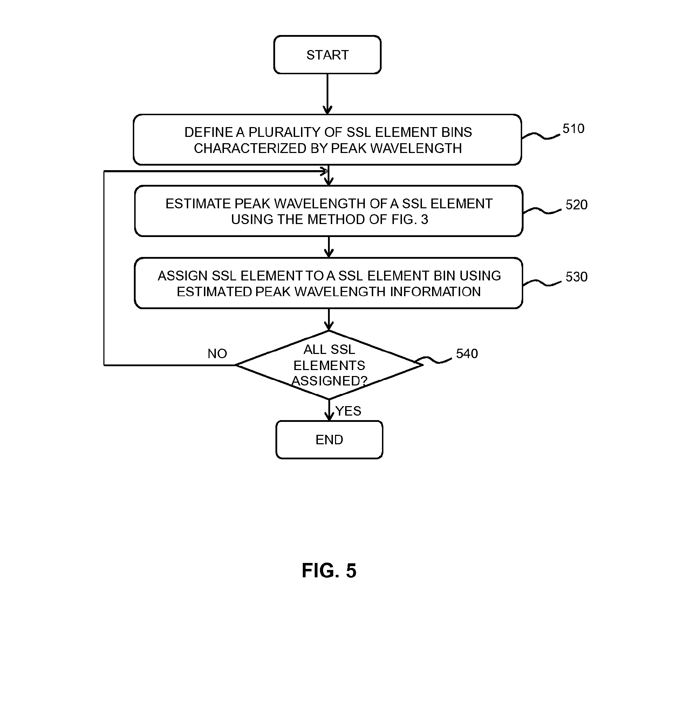

An embodiment of a binning method according to the present invention is shown in FIG. 5. First, the various bins (or categories) are defined in step 510, which bins are categorized based on peak wavelength information. Next in step 520, for a SSL element from a batch of SSL elements, the peak wavelengths are estimated using TAS in accordance with an embodiment of the method as shown in FIG. 3, after which in step 530 the SSL element is assigned to its appropriate bin based on its estimated peak wavelength. Steps 520 and 530 are repeated until all SSL elements from the batch have been assigned to one of the bins, as indicated in step 540.

It should be understood that many alternatives to the above binning method will be immediately apparent to the skilled person. For instance, rather than estimating the peak wavelength of an individual SSL element in step 520, the peak wavelengths of all SSL elements in the batch may be estimated in step 520 prior to proceeding to step 530. In this embodiment, the method will revert back from step 540 to step 530 until all SSL elements have been categorized. Also, in this embodiment, step 520 may take place before step 510 without departing from the teachings of the present invention.

At this point it is noted that preferably at least some and more preferably all of steps 510, 520, 530 and 540 are performed automatically, e.g. using a suitably programmed data processor.

Finally, it is noted that although the present application describes the method of electrically estimating a peak wavelength of a solid state lighting element in the context of binning procedures, it should be understood that this method may also be executed during the lifetime of the SSL element, e.g. to compensate for ageing or temperature effects. In such an embodiment, the measurement result may be used in a feedback mechanism to the driver circuits of the SSL element to compensate for such effects.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of electrically estimating a peak wavelength of a solid state lighting element, the method comprising:
determining a thermal admittance spectrum of the solid state lighting element, said spectrum identifying the energy levels of the trap states in the band gap of the solid state lighting element;
identifying the shallow trap states in said spectrum; and
estimating said peak wavelength from the respective energy gaps between the identified shallow trap states and the band gap boundary.

2. The method of claim 1, wherein the step of determining the thermal admittance spectrum comprises repeating the steps of:
bringing the solid state element to a desired temperature;
exposing the solid state lighting device to an excitation current of varying frequency; and
determining the change in the capacitance or conductance of the solid state lighting element as a function of said frequency.

3. The method of claim 2, wherein the step of bringing the solid state lighting device to a desired temperature comprises exposing the solid state lighting element to a pulse width modulated current comprising a first component for driving the solid state lighting element and a second component for estimating the temperature of the solid state lighting element.

4. The method of claim 2 or 3, further comprising varying a bias applied to the solid state lighting element to identify said shallow trap states in the thermal admittance spectrum.

5. The method of any of claims 1-3, further comprising applying a state selection threshold to said spectrum to identify the shallow trap states located in between said state selection threshold and a band gap boundary.

6. The method of claim 5, further comprising defining said state selection threshold by:
optically measuring the respective peak wavelengths of a plurality of solid state lighting elements;
for each solid state lighting element of said plurality, determining its thermal admittance spectrum; and
applying a fitting algorithm to the plurality of thermal admittance spectra to determine a state selection threshold for which the average of the respective peak wavelengths estimated from the respective energy gaps of the trap states in said spectra that are located in between said threshold and the band gap boundary deviates from the average of the measured respective peak wavelengths by less than a predefined threshold.

7. A method of binning a plurality of solid state lighting elements into a plurality of bins **characterised by** peak wavelength, the method comprising:
electrically estimating the peak wavelength of each solid state lighting element by the method of any of claims 1-6; and
assigning the solid state lighting element to one of said bins based on the estimated peak wavelength.

8. A solid state lighting element comprising:
a heterojunction defined by a quantum well material layer sandwiched between an n-type semiconductor layer and a p-type semiconductor layer;
a first current source driver adapted to provide said heterojunction with a first current output during an operating mode of the solid state lighting element;
a second current source driver adapted to provide said heterojunction with a variable frequency current output during a peak wavelength estimation mode of the solid state lighting element;
at least one sensing electrode in conductive contact with said heterojunction adapted to measure the change in capacitance or conductance across said heterojunction.

9. The solid state lighting element of claim 8, wherein the first current source driver and the second current source driver are different current source drivers.

10. The solid state lighting element of claim 8, wherein the first current source driver and the second current source driver are the same current source driver.

11. The solid state lighting element of any of claims 8-10, wherein the first current source driver comprises:
a first driver circuit adapted to provide said heterojunction with the first current output, wherein the first driver circuit has a control switch for interrupting the supply of the first current output;
a second driver circuit for generating a second current output for driving the solid state lighting element, wherein the second driver circuit has a control switch for interrupting the supply of the second current output; and
wherein the output of the first current source driver comprises the combination of the first and second driver circuit outputs, in the form of a pulse width modulated output current which alternates between a high current including the first current output generated by the first driver circuit and a low current comprising the second current output generated by the second driver circuit.

12. The solid state lighting element of any of claims 8-10, further comprising a temperature sensor.

13. The solid state lighting element of any of claims 8-12, wherein the solid state lighting element comprises a light emitting diode.

14. A device comprising the solid state lighting element of any of claims 8-13.
